# EUROPÄISCHE PATENTSCHRIFT

(11) **EP 1 733 410 B1**
(45) Veröffentlichungstag und Bekanntmachung des Hinweises auf die Patenterteilung: **24.12.2008**
(21) Anmeldenummer: 05716327.1
(22) Anmeldetag: 23.03.2005
(51) Int. Cl.: H01H 85/02

(54) **ANORDNUNG MIT EINER FAHRZEUG-SICHERUNG UND EINEM ANALOG/DIGITAL-WANDLER**
SYSTEM COMPRISING AN AUTOMOTIVE FUSE AND AN A/D CONVERTER
SYSTEME COMPRENANT UN FUSIBLE DE SECURITE POUR VEHICULE ET UN CONVERTISSEUR ANALOGIQUE/NUMERIQUE

(30) Priorität: 25.03.2004 DE 102004014662
(43) Veröffentlichungstag der Anmeldung: 20.12.2006
(73) Patentinhaber: AUDI AG, 85045 Ingolstadt (DE); EDAG Engineering + Design Aktiengesellschaft, 36039 Fulda (DE)
(72) Erfinder: HOCH, Dietmar, 07745 Jena (DE); BIBERGER, Christian, 84048 Mainburg (DE); TUMM, Hardo, 85053 Ingolstadt (DE)
(74) Vertreter: Patzelt, Heike Anna Maria
(86) Internationale Anmeldenummer: PCT/EP2005/003098
(87) Internationale Veröffentlichungsnummer: WO 2005/093773

(56) Entgegenhaltungen:
- DE-A1- 10 222 146
- DE-U1- 20 214 002
- US-A- 5 257 190
- US-A- 5 315 287

## Beschreibung

**Die Erfindung betrifft** eine Anordnung mit einer Fahrzeug-Sicherung und einem Analog/Digital-Wandler gemäss dem Oberbegriff des Patentanspruchs 1.

Die DE 299 11 177 U1 offenbart eine Anordnung mit einem Messinterface, weiches analoge Signale erfasst und digitalisiert. Dieses Messinterface ist mit einem Datenbus verbunden, der die digitalisierten Messwerte zu anderen Funktionseinheiten transportiert. Das Messinterface misst hierfür beispielsweise eine zeitlich veränderliche Spannung oder einen zeitlich veränderlichen Strom. Dieses analoge Messsignal oder ein davon proportionales Signal wird dann über einen Analog/Digital-Wandler (A/D-Wandler) digitalisiert.

**Nachteilig** hierbei ist jedoch, dass hierfür spezielle Messvorrichtungen, insbesondere Messwiderstände benötigt werden, die ansonsten keine weiteren Funktionen aufweisen. Diese Messvorrichtung und auch das Messinterface benötigen Platz.

Ferner sind Systeme bekannt, wie beispielsweise in der DE 202 14 002 U1 offenbart, die den Spannungsabfall an einem Messwiderstand erfassen, der auch als Sicherung dient. Das analoge Messsignal wird dann direkt oder verstärkt über eine lange Signalleitung zu einer Signalverarbeitungseinheit weitergeleitet. Erst dort wird der Messwert digitalisiert.

**Nachteilig** bei einem solchen System ist es, dass aufgrund von elektromagnetischer Einstrahlung auf lange Signalleitungen und/oder dem Einsatz zusätzlicher Verstärker die Messungen ungenau werden oder die Sicherungsfunktion der Fahrzeug-Sicherung ungünstig beeinflussen, wenn dieser als Messwiderstand verwendet wird. Außerdem sind diese Systeme hinsichtlich der Verdrahtung sehr aufwendig, da jede Messstelle separat verdrahtet werden muss. Da die bekannten zentralen Messsysteme größere Ausmaße annehmen ist die Mobilität nicht gegeben bzw. stark eingeschränkt, d.h. solche Systeme eignen sich nur für Laboraufbauten.

**Aufgabe der Erfindung ist es**, eine Anordnung mit einer Fahrzeug-Sicherung und einem A/D-Wandler aufzuzeigen mit der einerseits genaue Messungen zur Weiterleitung an ein Datenbussystem erzielt werden können, ohne dabei die Sicherungsfunktion, bei der ein Draht oder ein Blech bei zu hoher Belastung zerstört wird, zu beeinflussen.

Diese Aufgabe wird dadurch **gelöst**, dass ein A/D-Wandler direkt an seinem Eingang mit der Fahrzeug-Sicherung verbunden wird, wobei er den hier gemessenen analogen Messwert sofort und an Ort und Stelle digitalisiert und dann diesen digitalen Wert zur weiteren Verarbeitung zur Verfügung stellt.

Der **Vorteil** einer solchen Anordnung besteht darin, dass ein solches System fehlerfrei arbeitet, exakte Messwerte liefert, gegen elektromagnetische Strahlung weitestgehend unempfindlich ist und platzsparend aufgebaut werden kann. Der aus dem analogen Messwert exakt ermittelte Digitalwert kann dann auch über größere Strecken fehlerfrei, beispielsweise mit einem Buskabel, übertragen werden.

**Vorteilhafte Weiterbildungen** ergeben sich aus den Unteransprüchen. Hierbei erweist es sich als besonders vorteilhaft, wenn die Fahrzeug-Sicherung und der A/D-Wandler in einem gemeinsamen Gehäuse angeordnet sind und es sich bei diesem Gehäuse um ein Standard-Fahrzeug-Sicherungsgehäuse handelt. Weitere Vorteile ergeben sich, wenn ein Prozessor den digitalisierten Messwert vom A/D-Wandler aufnimmt, wobei es von Vorteil ist, wenn dieser Prozessor gleichfalls in Nachbarschaft im gleichen Gehäuse wie die Fahrzeug-Sicherung und der A/D-Wandler angeordnet ist. Hier ist es dann zweckmäßig, dass sich ein Temperatursensor zur Ermittlung der Umgebungstemperatur an der als Messwiderstand verwendeten Fahrzeug-Sicherung in unmittelbarer Nähe, und gegebenenfalls im gleichen Gehäuse wie die Fahrzeug-Sicherung befindet, um den analogen oder digitalisierten Messwert einer Temperaturkompensation unterziehen zu können.

Die Erfindung soll anhand von Ausführungsbeispielen, die in den Figuren 1 bis 4 dargestellt sind, erläutert werden. Es zeigen:
- **Figur 1:**: Bussystem mit mehreren erfindungsgemäßen Anordnungen
- **Figur 2:**: Anordnung mit einer Fahrzeug-Sicherung und einem A/D-Wandler zum digitalisieren von Messwerten
- **Figur 3:**: Platine mit einer Anordnung zum digitalisieren von Messwerten
- **Figur 4:**: Gehäuseformen für Anordnungen zum digitalisieren von Messwerten mit integrierter Fahrzeug-Sicherung.

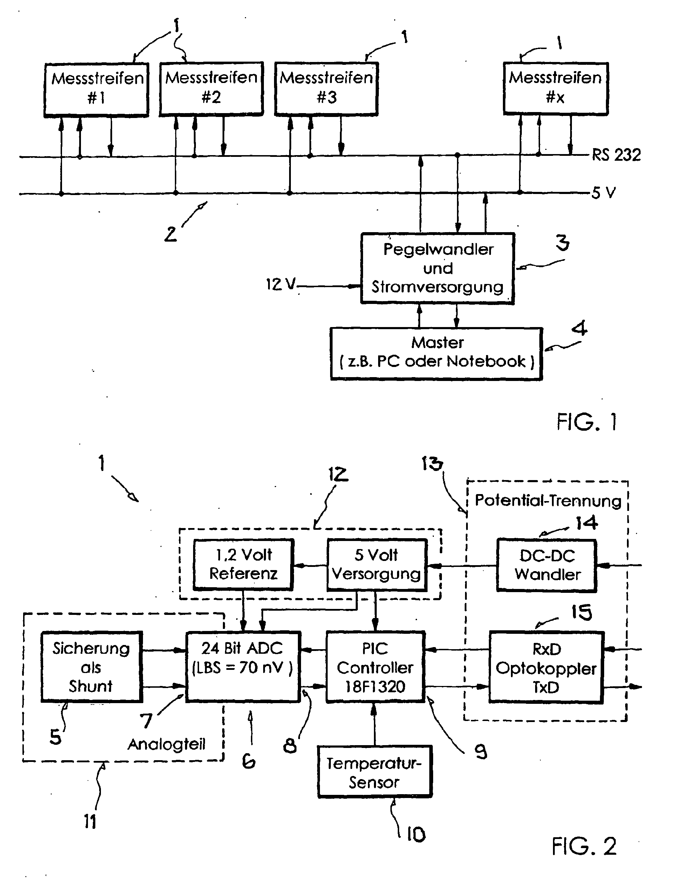

**Figur 1** zeigt mehrere erfindungsgemäße Anordnungen **1**, die an einem Bussystem **2** angeschlossen sind. Die Anordnungen **1**, die zumindest aus einer Fahrzeug-Sicherung und einem A/D-Wandler bestehen, sind an den Datenbus **2** angeschlossen. Die Anordnungen **1** stehen in Kontakt mit Steuergeräten, Schaltkreisen, Funktionseinheiten oder ähnlichen Vorrichtungen, die über eine Fahrzeug-Sicherung gegen zu hohe elektrische Belastungen abgesichert werden müssen. Diese Vorrichtungen erzeugen Signale, die der Fahrzeugelektronik zur Weiterverarbeitung zur Verfügung gestellt werden müssen. Diese Signale müssen gemessen und überprüft werden. Hierbei ist unter Überprüfung gemeint, dass die Höhe des Signals keinen Schaden verursachen kann. Aus diesem Grund wird, wie später dargestellt, die Fahrzeug-Sicherung benötigt. Die Anordnung **1** digitalisiert den gemessenen Signalwert und bereitet ihn so auf, dass er über den Datenbus **2** zur Weiterverarbeitung verschickt werden kann. Gleichfalls versorgt der Datenbus **2** die Anordnungen **1** mit der benötigten Spannung, die am Zweidrahtbussystem abgegriffen werden kann. Ferner befindet sich am Datenbus **2** der Pegelwandler mit der Stromversorgung **3**, der wiederum die Busleitung **2** mit Energie versorgt und der die digitalisierten Signale, die sich aus den ermittelten Messwerten ergeben, wieder umwandelt und einer Mastereinheit **4** zuführt. Bei dieser Mastereinheit **4** kann es sich beispielsweise um einen Personal Computer (PC) oder einem Personal Digital Assistent (PDA) handeln, welche die unterschiedlichen Signale erfassen, weiterverarbeiten und gegebenenfalls aufgrund der daraus resultierenden Ergebnisse Befehle an die Busleitung zur Weitergabe an die entsprechenden Steuergeräte, Funktionseinheiten oder ähnlichen Vorrichtungen verschicken.

**Figur 2** zeigt ein Ausführungsbeispiel für eine Anordnung mit einer Fahrzeug-Sicherung und einem A/D-Wandler zum digitalisieren von Messwerten. Die Anordnung **1** besteht aus einer Fahrzeug-Sicherung **5**, die es beispielsweise in einer 5A, 10A, 20A oder 30A Ausführung gibt. Diese Sicherung **5** besteht im wesentlichen aus einem Leiterblech oder Leiterdraht, der geschmolzen oder andersartig zerstört wird, wenn ein zu großer Strom über ihn fließt. In unmittelbarer Nähe der Sicherung **5** befindet sich der A/D-Wandler **6**. Bei dem A/D-Wandler **6** handelt es sich um einen 24Bit-Wandler, der einen LSB-Wert von 70 nV aufweist (LSB = Least Significant Bit). Der Eingang **7** des A/D-Wandlers **6** ist mit der Fahrzeug-Sicherung **5** verbunden. Das heißt an der Sicherung **5** wird der zu digitalisierende Messwert abgegriffen. Die Sicherung **5** und der Eingang **7** des A/D-Wandlers **6** bilden den Analogteil **11** der Anordnung **1**. Der analoge Messwert, der an der Sicherung **5** gemessen wird, ist im Ausführungsbeispiel die an der Sicherung anliegende Spannung resultierend zum fließenden Strom oder eine analoge Spannung bei Messung ohne Sicherung.
Ferner ist der A/D-Wandler **6** mit einer Spannungseinheit **12** verbunden, die sowohl die Versorgungsspannung als auch die Referenzspannung für den A/D-Wandler **6** zur Verfügung stellt. Im Ausführungsbeispiel beträgt die Referenzspannung 1,2 V und die Versorgungsspannung 5 V. Im A/D-Wandler **6** wird der analoge Messwert in einen digitalen Wert umgewandelt, dieser Digitalwert kann am Ausgang **8** des A/D-Wandlers **6** ausgelesen werden. Im Ausführungsbeispiel steht der A/D-Wandler **6** in Kontakt mit einem Prozessor **9**, wobei dieser Prozessor **9** den digitalen Ausgangswert **8** des A/D-Wandlers **6** weiterverarbeitet. Dieser Prozessor **9** steht auch in Verbindung mit einem Temperatursensor **10**, der in der Nähe der Sicherung **5** die Umgebungstemperatur ermittelt. Im Prozessor **9** erfolgt zusammen mit dem ermittelten Temperaturwert eine Temperaturkompensation. Der zur Verfügung stehende digitale Messwert des gewandelten Analogwertes wird durch den Prozessor **9**, der sich in unmittelbarer Nähe zum A/D-Wandler **6** befindet, ausgewertet und über ein Bussystem **2** bei Bedarf an einen Computer **4** gesendet. Gleichzeitig wird die Temperatur der Sicherung **5** erfasst, die zur Temperaturkompensation des Messwertes dient. Der Prozessor **9** übernimmt in diesem Ausführungsbeispiel die Steuerung des A/D-Wandlers **6**, die Berechnung des über den Spannungsabfall des originalen Sicherungsdrahtes eingeprägten Stromes und die befehlsgesteuerte Kommunikation bzw. den Datentransfer zum Computer **4**. Die Steuerung des A/D-Wandlers **6** beinhaltet das Auslesen der Daten und das Einstellen von Parametern der A/D-Wandlung dieses Bausteins. Die Berechnung beinhaltet die Umrechnung des A/D-Wertes vom Wandler in einen temperaturkompensierten Stromwert. Dabei wird die gemessene Temperatur zur Temperaturkompensation des A/D-Messwertes herangezogen. Dies findet unter Benutzung eines Temperatur-Strom-Kennfeldes statt, das sich beispielsweise im nichtflüchtigen Speicher des Prozessors **9** befindet. Der Datentransfer zum Computer wird durch Befehle gesteuert. Die Messung des Stromes kann synchron erfolgen, d.h. alle Sicherungen bekommen den Befehl zum Messen und beginnen zeitgleich mit der Messung. Danach werden die Teilnehmer **1** am Bus **2** nacheinander vom Computer **4** ausgelesen. Ferner befindet sich in diesem Ausführungsbeispiel eine Potentialtrennung **13** in der Anordnung **1**. Die Potentialtrennung **13** weist einen Optokoppler **15** auf, der das Ausgangssignal vom Prozessor **9** in den Datenbus **2** verschickt, wobei eine komplette elektrische Entkopplung vom Sicherungsdraht erfolgt. Ferner weist die Potentialtrennung **13** einen Gleichstrom-Gleichstrom-Wandler (DC-DC-Wandler) **14** auf, der die Spannungseinheit **12** mit Energie versorgt. Die Versorgungseinheit der Spannungseinheit **12** versorgt auch den Prozessor **9** mit Energie.

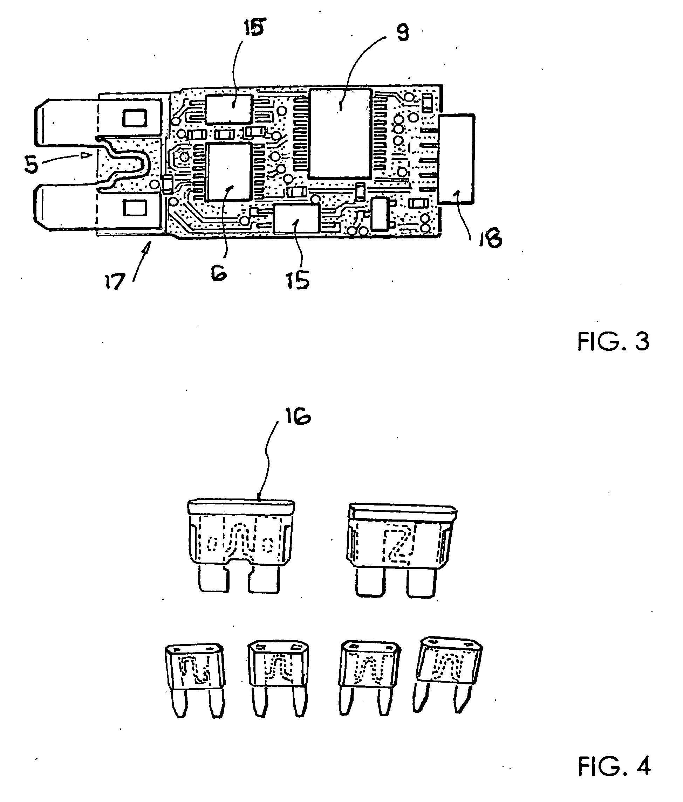

**Figur 3** zeigt eine Platine mit einer Anordnung nach Figur 2. In diesem Ausführungsbeispiel ist die Oberseite einer Platine **17** dargestellt, die zusammen mit der Unterseite die komplette Anordnung **1** beinhaltet. Hier befindet sich auf der Oberseite die herkömmliche originale Fahrzeug-Sicherung **5**, der A/D-Wandler-Chip **6**, der Prozessor **9**, die Optokoppler **15** zur galvanischen Trennung des Bussystems und der Stecker **18** zur Anbindung an die Stromversorgung und dem seriellen Bussystem. Mit einer solchen Anordnung kann eine sehr hohe bisher mit herkömmlichen Messsystemen nicht erreichte Messgenauigkeit erreicht werden. Ein solcher Aufbau kann beispielsweise die folgenden technischen Daten aufweisen. Eine solche Platine kann also weiterhin als normale Sicherung verwendet werden und passt auch in das Sicherungsfach für eine Fahrzeug-Sicherung im Fahrzeug. Die technischen Daten für einen solchen Aufbau sind beispielsweise:

| | |
|---|---|
| Messbereich Strom: | Dieser entspricht der eingesetzten Sicherung vom Typ 5A, 10A, 20A oder 30A. Eine Gesamtstrommessung ist möglich. |
| | |
| Messbereich Spannung: | +/- 60 Volt (bei einer Messung einer Analogspannung ohne SI-Draht). |
| | |
| Messbereich Temperatur: | -40 °C bis +80 °C |
| | |
| Genauigkeit: | +/- 100 µA, Rauschen ca. +/- 50 µA |
| | |
| Messmethode: | Original Sicherungsdraht als Messwiderstand, Digitalisierung am A/D-Wandler und Berechnung im Rechnerteil direkt auf der Sicherung |
| | |
| Entkopplung: | Komplette Entkopplung vom Fahrzeug durch eine Gleichstrom-Gleichstrom-Spannungsversorgung und optoentkoppelte Signalleitungen |
| | |
| Anzahl der Messstellen: | Bis 200 |
| | |
| Ausgegebene Messwerte: | Gemessener Strom, Temperatur an der Sicherung |
| | |
| Messtakt: | synchrone Messung, asynchrone Datenübertragung, 100 Messstellen werden pro Sekunde ausgelesen (fast measuring), eine Einzelmessung mit Einzelabfrage dauert ca. 200 ms |
| | |
| Temperaturbereich: | -40 °C bis 80°C (Einsatzbedingungen) |
| | |
| Größe eines Messstreifens: | ca. 14 mm x 30 mm |
| | |
| Bussystem: | 2-Draht, seriell |
| | |
| Schnittstelle: | RS232C |
| | |
| Systemkonfiguration: | 25, 50 oder 100 Messstellen, heterogenes System mit Strom-, Spannungs- und Temperaturmessstellen am gleichen Bus. |

Mit einem solchen Aufbau ist es möglich einen analogen Messwert in einen digitalen Wert umzuwandeln und diesen Wert digital beispielsweise über ein Bussystem an andere Einheiten beispielsweise Steuergeräte zu verschicken ohne dass die Übertragung fehlerhaft ist.

**Figur 4** zeigt verschiedene Gehäuseformen für eine solche Anordnung. Die Gehäuse **16** entsprechen von ihren Abmessungen denen herkömmlicher Fahrzeug-Sicherungen. Jedoch weisen sie im Innern zumindest einen A/D-Wandler **6** auf oder sogar eine Platine **17**, wie sie in Figur 3 dargestellt ist. Eine solche Anordnung kann platzsparend an derselben Stelle positioniert werden, an der vorher die Fahrzeug-Sicherung allein positioniert war. Dadurch ergibt sich ein platzsparender und kostengünstiger Aufbau.

Mit einem solchen Messsystem ist es möglich, ohne großen Verdrahtungsaufwand und mit sehr hoher Genauigkeit Messwerte über originale handelsübliche Fahrzeug-Sicherungen, die sich im Fahrzeug in Betrieb befinden, zu erfassen. Die Erfassung des Messwertes erfolgt analog. Unmittelbar danach wird der analoge Messwert digitalisiert und dann erst weiterverarbeitet.

Ein solches System ist mobil einsetzbar und kann im Fahrzeug verbleiben ohne die ursprüngliche Sicherungsfunktion der Fahrzeug-Sicherung zu beeinflussen.

Besonders vorteilhaft erweist sich ein solches Sicherungsmodul in Erprobungsfahrzeugen, die dort während der Erprobungslebensdauer verbleiben können. Jedoch können solche Systeme auch für Serienfahrzeuge verwendet werden.

## Patentansprüche

1. Anordnung (1) mit einer Fahrzeug-Sicherung (5) zur Unterbrechung von mindestens einem Stromkreis bei Überlast und mindestens einem Analog/Digital-Wandler (6) zur Erfassung und zur Umwandlung eines analogen Messwerts, der am Eingang (7) des Analog/Digital-Wandlers (6) eingespeist wird, in einen digitalen Messwert, der am Ausgang (8) des Analog/Digital-Wandlers (6) zur Weiterverarbeitung zur Verfügung gestellt wird, **dadurch gekennzeichnet, dass**
der Eingang (7) des Analog/Digital-Wandlers (6) direkt mit der Fahrzeug-Sicherung (5) verbunden ist, wobei die Fahrzeug-Sicherung (5) den analogen Messwert für den Analog/Digital-Wandler (6) erzeugt und
der Analog/Digital-Wandler (6) in demselben Gehäuse wie die Fahrzeug-Sicherung (5) angeordnet ist, um den Messwert direkt nach seiner Erfassung zu digitalisieren..

2. Anordnung (1) mit einer Fahrzeug-Sicherung (5) und einem AnalogDigital Wandler (6) nach Patentanspruch 1, **dadurch gekennzeichnet, dass**
ein Prozessor (9) mit dem Ausgang (8) des Analog/Digital-Wandlers (6) verbunden ist, an dem der digitalisierte Messwert anliegt.

3. Anordnung (1) mit einer Fahrzeug-Sicherung (5) und einem AnalogDigital Wandler (6) nach Patentanspruch 1, **dadurch gekennzeichnet, dass**
in dem gemeinsamen Gehäuse (16) von Fahrzeug-Sicherung (5) und Analog/Digital-Wandler (6) auch ein Prozessor (9) angeordnet ist.

4. Anordnung (1) mit einer Fahrzeug-Sicherung (5) und einem AnalogDigital Wandler (6) nach Patentanspruch 1 oder 2, **dadurch gekennzeichnet, dass**
ein Temperatursensor (10) in Nachbarschaft von der Fahrzeug-Sicherung (5) angeordnet ist

5. Anordnung (1) mit einer Fahrzeug-Sicherung (5) und einem AnalogDigital Wandler (6) nach Patentanspruch 1 oder 3, **dadurch gekennzeichnet, dass**
ein Temperatursensor (10) in dem gemeinsamen Gehäuse (16) von Fahrzeug-Sicherung (5) und der Analog/Digital-Wandler (6) angeordnet ist

6. Anordnung (1) mit einer Fahrzeug-Sicherung (5) und einem AnalogDigital Wandler (6) nach Patentanspruch 4 oder 5, **dadurch gekennzeichnet, dass**
der Temperatursensor (10) mit dem Prozessor (9) verbunden ist, um am Messwert eine Temperaturkompensation durchzuführen.

7. Verwendung für eine Anordnung (1) nach Patentanspruch 1, **dadurch gekennzeichnet, dass**
die Anordnung (1) als digitaler Messwertgeber für ein Datenbussystem verwendet wird.

## Claims

1. Arrangement (1) with a vehicle, electrical cutout (5) for interrupting at least one circuit in the case of electrical overload and at least one analog/digital converter (6) for determining and converting a measured analog value, which is stored at the input (7) of the analog/digital converter (6), into a digital one, which is made available for further processing at the output (8) of the analog/digital converter,
**characterized in that**
the input (7) of the analog/digital converter (6) is directly connected to the vehicle electrical cutout (5) whereby the cutout (5) produces the measured analog value for the analog/digital converter (6) and
**in that** the analog/digital converter (6) is disposed in the same housing as the vehicle electrical cutout (5), in order to digitalize the measured value directly after it has been determined.

2. Arrangement (1) with a vehicle electrical cutout (5) and an analog/digital converter (6) in accordance with claim 1, **characterized in that**
a processor (9) is connected to the output (8), at which the measured digitalized value is present, of the analog/digital converter (6).

3. Arrangement (1) with a vehicle electrical cutout (5) and an analog/digital converter (6) in accordance with claim 1, **characterized in that**
a processor (9) is also disposed in the common housing (16) of the vehicle electrical cutout (5) and the analog/digital converter (6).

4. Arrangement (1) with a vehicle electrical cutout (5) and an analog/digital converter (6) in accordance with claims 1 or 2, **characterized in that**
a temperature sensor (10) is disposed close to the vehicle electrical cutout (5).

5. Arrangement (1) with a vehicle electrical cutout (5) and an analog/digital converter (6) in accordance with claims 1 or 3, **characterized in that**
a temperature sensor (10) is disposed in the common housing (16) of the vehicle electrical cutout (5) and the analog/digital converter (6).

6. Arrangement (1) with a vehicle electrical cutout (5) and an analog/digital converter (6) in accordance with claims 1 or 3, **characterized in that**
the temperature sensor (10) is connected to the processor (9), so that a temperature adjustment is made to the measured value.

7. Use of the arrangement (1) in accordance with claim 1, **characterized in that** the arrangement (1) is used as a digital measuring transducer for a data bus system.

## Revendications

1. Système (1) comprenant un fusible de véhicule (5) pour interrompre au moins un circuit électrique en cas de surcharge et au moins un convertisseur analogique numérique (6) pour détecter et convertir une valeur de mesure analogique, qui est introduite à l'entrée (7) du convertisseur analogique numérique (6), en une valeur de mesure numérique qui est disponible à la sortie (8) du convertisseur analogique numérique (6) à des fins de traitement ultérieur, **caractérisé**
**en ce que** l'entrée (7) du convertisseur analogique numérique (6) est reliée directement au fusible de véhicule (5), le fusible de véhicule (5) générant la valeur de mesure analogique pour le convertisseur analogique numérique (6) et
**en ce que** le convertisseur analogique numérique (6) est disposé dans le même boîtier que le fusible de véhicule (5) afin de numériser la valeur de mesure directement après sa détection.

2. Système (1) comprenant un fusible de véhicule (5) et un convertisseur analogique numérique (6) selon la revendication 1, **caractérisé en ce que**
un processeur (9) est relié à la sortie (8) du convertisseur analogique numérique (6) à laquelle est présente la valeur de mesure numérisée.

3. Système (1) comprenant un fusible de véhicule (5) et un convertisseur analogique numérique (6) selon la revendication 1, **caractérisé en ce que**
un processeur (9) est également disposé dans le boîtier (16) commun du fusible de véhicule (5) et du convertisseur analogique numérique (6).

4. Système (1) comprenant un fusible de véhicule (5) et un convertisseur analogique numérique (6) selon la revendication 1 ou 2, **caractérisé en ce que**
une sonde de température (10) est disposée dans le voisinage du fusible de véhicule (5).

5. Système (1) comprenant un fusible de véhicule (5) et un convertisseur analogique numérique (6) selon la revendication 1 ou 3, **caractérisé en ce que**
une sonde de température (10) est disposée dans le boîtier (16) commun du fusible de véhicule (5) et du convertisseur analogique numérique (6).

6. Système (1) comprenant un fusible de véhicule (5) et un convertisseur analogique numérique (6) selon la revendication 4 ou 5, **caractérisé en ce que**
la sonde de température (10) est reliée au processeur (9) afin d'effectuer une compensation de température sur la valeur de mesure.

7. Utilisation pour un système (1) selon la revendication 1, **caractérisé en ce que** le système (1) est utile en tant que transmetteur de valeurs de mesure pour un système de bus de données.
